# EUROPEAN PATENT SPECIFICATION

(11) **EP 3 021 148 B1**
(45) Date of publication and mention of the grant of the patent: **29.12.2021**
(21) Application number: 15191230.0
(22) Date of filing: 23.10.2015
(51) Int. Cl.: G02B 6/42

(54) **RUGGEDIZED SMALL FORM FACTOR OPTICAL SUB-ASSEMBLY (OSA) AND DATA BUS-IN-A-BOX (BIB)**
STOSSGESCHÜTZTE OPTISCHE UNTERBAUGRUPPEN (OSA) MIT KLEINEM FORMFAKTOR UND DATENBUS-IN-A-BOX (BIB)
SOUS-ENSEMBLE OPTIQUE (OSA) DE PETIT FACTEUR DE FORME RENFORCÉ ET DONNÉES BUS-IN-A-BOX (BIB)

(30) Priority: 05.11.2014 US 201414533715
(43) Date of publication of application: 18.05.2016
(73) Proprietor: The Boeing Company, Chicago, IL 60606-1596 (US)
(72) Inventor: CHAN, Eric Y., Chicago, Illinois 60606-2016 (US); TRUONG, Tuong K., Chicago, Illinois 60606-2016 (US); KOSHINZ, Dennis G., Chicago, Illinois 60606-2016 (US); PANG, Henry B., Chicago, Illinois 60606-2016 (US)
(74) Representative: Boult Wade Tennant LLP

(56) References cited:
- WO-A1-2013/097449
- DE-U1- 8 211 582
- US-A- 4 650 276
- US-A- 4 838 641
- US-A- 5 165 002
- None

## Description

### BACKGROUND

The present disclosure relates to optical sub-assemblies and data buses. In particular, it relates to a low cost, connectorless, ruggedized small form factor optical sub-assembly (OSA) and data bus-in-a-box (BiB) design and assembly process.

Currently, some system data bus architectures (e.g., an ARINC plastic optical fiber (POF) 629 data bus) employed in aircraft (e.g., a modern aircraft) require an individually packaged optical media converter (OMC) for each channel. They also require individually packaged passive optical star couplers. These individually packaged units are interconnected together by fully jacketed aircraft POF cables that are subjected to abuse during installation. The connectors required for these packages are not only heavy, bulky, and costly, but also add significant optical attenuation to the system's optical power budget. The optical media converters (OMCs) and optical star couplers also require custom designed support brackets and rails to mount them to the aircraft structure members. Each OMC (which contains a transmit (Tx) optical sub-assembly (OSA) and a receive (Rx) OSA) and optical star coupler must be manufactured and tested individually, thereby incurring much more time and cost. When an OMC fails, an aircraft mechanic must remove it and install a new OMC in its place, which requires additional time and cost. As such, there is a need for an improved data bus architecture design.

US4650276, according to its abstract, states an apparatus couples optical fiber to an optoelectronic component with a collet, a cylindrical member, a connector, and hermetically sealing means. The collet has a central orifice through a knurled end portion, a central portion with a male thread, and a second end portion formed with a slotted cone sleeve. The cylindrical member has opposed centrosymmetric recesses that meet, forming a small axially oriented aperture. One recess is formed with an axial female thread, with a conical indentation terminating at the aperture. The female thread can to engage with the collet male thread. Thread engagement of member and collet results in engagement of the member at the conical indentation with the coned sleeve, drawing the slotted sides inwardly, firmly gripping the collet held optical fiber. The other recess has a second axial female thread from the opposite end of the member toward the aperture. The member has a radially directed sight hole. The connector couples the optoelectronic component to an electronic circuit. Its peripheral surface has a second male thread to engage with the second female thread of the member. Orientation of the collet held fiber with respect to the optoelectronic component can be varied by adjusting the second threads, with observation through the sight hole.

In DE8211582 there is described a bushing for a glass optical fiber with a housing made of metal, in which an electro-optical element is enclosed, the optical fiber being fastened with a glass enamel in an opening of the housing opposite the electro-optical element.

### SUMMARY

The present disclosure relates to a method, system, and apparatus for an optical sub-assembly (OSA), which may be employed in the disclosed data BiB design.

There is described herein a method for manufacturing an optical sub-assembly (OSA), the method comprising: inserting a first end of a lock nut into a first cavity of a package body; inserting a first end of a transistor outline (TO) can into a second cavity of the package body; stripping a portion of a jacket from an end of an optical fiber, thereby exposing bare optical fiber at the end of the optical fiber; inserting the end of the optical fiber into a second end of the lock nut such that the bare optical fiber passes into the package body and at least a portion of the bare optical fiber inserts into the second cavity, wherein the lock nut has a turning knob for locking the optical fiber inserted into the package body; and dispensing glue into a third cavity of the package body to environmentally seal the bare optical fiber. In one or more embodiments, the TO can is a hermetically sealed TO can.

In at least one embodiment, the TO can comprises a lens.

In one or more embodiments, the OSA is tilted approximately thirty (30) degrees from a plane of a mounting surface for the OSA.

In at least one embodiment, the method further involves securing, with at least one screw, a bottom side of the OSA to a mounting surface of a board by applying the screw(s) through an opening in the board into a mounting screw hole on the bottom side of the OSA, thereby mounting the OSA to the board.

In one or more embodiments, the board is an optical media converter (OMC) printed circuit board (PCB).

In at least one embodiment, the OSA is an optical transmitter. In some other embodiments, the OSA is an optical receiver.

In one or more embodiments, the optical fiber (e.g., plastic optical fiber), including the jacket, has a typical diameter of approximately 2.2 millimeter (mm), and a diameter size down to approximately 1.5 mm is acceptable (i.e. the diameter ranges from approximately 1.5 mm to approximately 2.2 mm). In some embodiments, the bare optical fiber (e.g., plastic optical fiber), without the jacket, has a diameter of approximately 1 millimeter (mm).

In at least one embodiment, the glue is a military specification (mil-spec) grade epoxy.

In one or more embodiments, the method further involves dispensing glue into the second end of the lock nut to secure the lock nut to the package body.

In at least one embodiment, the method further involves manufacturing the package body by molding the package body from a cool polymer material.

There is described herein an apparatus for an optical sub-assembly (OSA), the apparatus comprising: a package body; a lock nut, wherein a first end of the lock nut is inserted into a first cavity of the package body; a transistor outline (TO) can, wherein a first end of the TO can is inserted into a second cavity of the package body; and a jacketed optical fiber, comprising a jacket and a bare optical fiber, wherein the bare optical fiber is exposed at the end of the jacketed optical fiber, wherein the end of the optical fiber is inserted into a second end of the lock nut such that the bare optical fiber passes into the package body and at least a portion of the bare optical fiber is inserted into the second cavity, wherein the lock nut has a turning knob for locking the optical fiber inserted into the package body, and wherein glue is provided in a third cavity of the package body, thereby environmentally sealing the bare optical fiber.

In at least one embodiment, the TO can is hermetically sealed.

In one or more embodiments, the package body is manufactured from a molded cool polymer material.

The features, functions, and advantages can be achieved independently in various embodiments of the present disclosure or may be combined in yet other embodiments.

### Drawings

These and other features, aspects, and advantages of the present disclosure will become better understood with regard to the following description, appended claims, and accompanying drawings where:
FIGS. 1A and 1B are diagrams showing the disclosed optical sub-assembly (OSA) package body, in accordance with at least one embodiment of the present disclosure.
FIG. 2 is a diagram illustrating the assembly process of the disclosed OSA, in accordance with at least one embodiment of the present disclosure.
FIGS. 3A and 3B are additional diagrams illustrating the assembly process of the disclosed OSA, in accordance with at least one embodiment of the present disclosure.
FIG. 4 is a flow chart of the disclosed method for manufacturing an OSA, in accordance with at least one embodiment of the present disclosure.
FIGS. 5A, 5B, and 5C are diagrams illustrating the transmit (Tx) optical media converter (OMC) printed circuit board (PCB) design and assembly process, in accordance with at least one embodiment of the present disclosure.
FIG. 6 is a diagram showing the assembly process of mounting a Tx OSA to a Tx OMC PCB, in accordance with at least one embodiment of the present disclosure.
FIGS. 7A and 7B are diagrams illustrating the assembly process of a receiver (Rx) OSA, in accordance with at least one embodiment of the present disclosure.
FIGS. 8A, 8B, and 8C are diagrams illustrating the Rx OMC PCB design and assembly process, in accordance with at least one embodiment of the present disclosure.
FIG. 9 is a diagram showing the assembly process of mounting a Rx OSA to a Rx OMC PCB, in accordance with at least one embodiment of the present disclosure.
FIG. 10 is a diagram showing the assembly of optical media converters (OMCs) (comprising Tx OMC portions and Rx OMC portions) mounted onto a copper core PCB mother board, in accordance with at least one embodiment of the present disclosure.
FIG. 11 is a diagram showing the details of a OMC (comprising a Tx OMC portion and an Rx OMC portion) mounted onto a copper core PCB mother board, in accordance with at least one embodiment of the present disclosure.
FIG. 12 is a diagram showing the assembled PCB mother board inserted into the back plane of a 3 MCU sized data bus-in-a-box (BiB), in accordance with at least one embodiment of the present disclosure.
FIG. 13 is a diagram showing the details of the assembled PCB mother board inserted into the back plane of a 3 MCU sized data bus-in-a-box (BiB), in accordance with at least one embodiment of the present disclosure.
FIG. 14 is a diagram showing the connections of plastic optical fiber (POF) from POF star couplers to the Tx OMC portions and the Rx OMC portions and to optical connectors on the side of the data BiB, in accordance with at least one embodiment of the present disclosure.
FIG. 15 is a diagram illustrating an interior view of the data BiB after final assembly, in accordance with at least one embodiment of the present disclosure.

### Description

The methods and apparatus disclosed herein provide an operative system for a low cost, connectorless, ruggedized small form factor optical sub-assembly (OSA) and data bus-in-a-box (BiB) design and assembly process. The present disclosure involves the design and fabrication process of a tilted optical sub-assembly (OSA). The disclosed OSA provides maximum space allocation for the electronic circuits on the printed circuit board (PCB) (e.g., mother board) of the disclosed data BiB design; while at the same time, maintains the optimum optical performance for both the transmitter and receiver to provide a minimum of a 54 decibels (dB) power budget required for the POF 629 system data bus of a modern aircraft.

The disclosed OSA design uses a POF lock nut and a high precision, high thermal conductivity and electrically insulating, molded, cool polymer package body to embed the laser transmitter and receiver in a hermetically sealed transistor outline (TO) can package. The cool polymer package body is precision molded to align a POF to the laser transmitter and receiver passively, without labor intensive POF active alignment steps. Securing the lock nut together with using a mil-spec grade epoxy provides an environmental seal to the POF end face to the surface of the TO can. The use of a POF lock nut eliminates the need for connectors to couple the POF, thereby further reducing the assembly cost for the data BiB POF 629 system. The disclosed OSA design meets the low cost, high performance, and stringent environmental requirements of the POF 629 system data bus for aircraft production.

A POF 629 data system bus architecture for an exemplary modern aircraft requires thirty (30) optical media converters (OMCs). The disclosed data BiB design utilizes a 3 MCU sized box (i.e. 3.56 inches (") width (W) x 7.46" height (H) x 12.76" depth (D)). As such, the 30 optical transmitters and receivers need to be incorporated into a small sized box (e.g., 3 MCU sized box). Since electronic circuits occupy most of the space on the PCB (e.g., mother board) of the BiB design, a conventional flat surface, fiber optic transceiver package form factor is too large to be incorporated onto the disclosed BiB PCB. To solve this problem, each OMC employs a titled Rx OSA and a tilted Tx OSA. The disclosed tilted OSA design allows for packaging of the 30 OMCs into the small sized box of the disclosed data BiB.

The present disclosure presents the concept of replacing the copper bus cables, the quad stub cables, the couplers, and the complex coupler panel assembly of the ARINC 629 system bus that is currently employed in modern airplanes with the disclosed POF 629 optical data BiB. The basic approach of the POF 629 data BiB is to replace the current mode coupler data bus with plastic optical fiber (POF), optical media converters (OMCs), and POF couplers (e.g., star couplers). The projected weight savings by using the disclosed data BiB, instead of using a conventional copper ARINC 629 data bus, is over 100 pounds (lbs) per airplane, and the projected cost savings is over $100K per airplane.

An exemplary modern aircraft system bus architecture connects up to 30 line replaceable units (LRUs) in the front (or forward) section of the aircraft and connects 2 to 4 LRUs in the back (or aft) section of the airplane. To achieve a desired size, weight, power, and cost reduction for the disclosed system data BiB design, the challenge was to package and assemble 30 (e.g., 25 plus 5 spare) OMCs in a compact 3 MCU (or 4 MCU) sized avionics box, while at the same time achieve high reliability and ruggedness that are required by the commercial avionics environment. The description of the figures below discusses the disclosed optical sub-assembly (OSA) design and the assembly process for the disclosed data BiB. The OSA design and assembly process are the key to achieving the desired size, weight, power, and cost reduction objectives for the POF 629 system data bus in the modern airplane.

Each OMC in the data BiB is made up of a transmitter (Tx) PCB and a receiver (Rx) PCB. Each Tx and Rx PCB are approximately 2" by 1" in dimensions, and are manufactured from two-sided copper core PCB to allow for maximum space allocation for the electronics components, such as inductors, capacitors, resistors, and integrated circuit (IC) chips, which take up a large portion of the PCB space. As such, the design of the OSA needs to be compact and to be able to occupy a minimum space on the PCB. Regarding the disclosed Tx OSA design, the Tx OSA houses a laser in a hermetically sealed transistor outline (TO) can, which needs to be precisely coupled to the POF to achieve maximum transmit output power. For the disclosed Rx OSA design, the Rx OSA houses a receiver in a hermetically sealed TO can with a lens cap, and the receiver TO can needs to be precisely coupled to the POF to achieve maximum receiver sensitivity. The disclosed Tx OSA and Rx OSA designs for the system bus of the POF 629 architecture are able to assure (as required for the system data bus of some modern aircraft) a minimum of a 54 decibel (dB) power budget over the operating temperature range of -40° Celsius (C) to 85°C, and at the same time maintain this performance over twenty (20) years of operating life time under stringent avionics environments, such as high vibration, humidity, and contamination.

In the following description, numerous details are set forth in order to provide a more thorough description of the system. It will be apparent, however, to one skilled in the art, that the disclosed system may be practiced without these specific details. In the other instances, well known features have not been described in detail so as not to unnecessarily obscure the system.

Embodiments of the present disclosure may be described herein in terms of functional and/or logical block components and various processing steps. It should be appreciated that such block components may be realized by any number of hardware, software, and/or firmware components configured to perform the specified functions. For example, an embodiment of the present disclosure may employ various integrated circuit components, e.g., memory elements, digital signal processing elements, logic elements, look-up tables, or the like, which may carry out a variety of functions under the control of one or more microprocessors or other control devices. In addition, those skilled in the art will appreciate that embodiments of the present disclosure may be practiced in conjunction with, and that the system described herein is merely one example embodiment of the present disclosure.

For the sake of brevity, conventional techniques and components related to optical sub-assemblies (OSAs) and data buses, and other functional aspects of the system (and the individual operating components of the systems) may not be described in detail herein. Furthermore, the connecting lines shown in the various figures contained herein are intended to represent example functional relationships and/or physical couplings between the various elements. It should be noted that many alternative or additional functional relationships or physical connections may be present in an embodiment of the present disclosure.

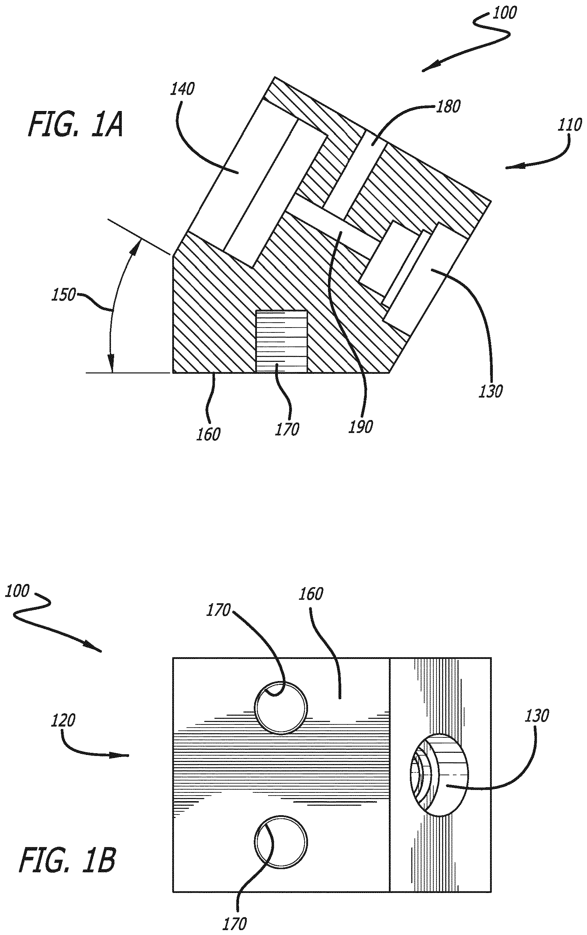

FIGS. 1A and 1B are diagrams showing the disclosed optical sub-assembly (OSA) package body 100, in accordance with at least one embodiment of the present disclosure. In particular, FIG. 1A shows the side view 110 of a tilted Tx OSA package body 100, and FIG. 1B shows the bottom 120 view of the tilted Tx OSA package body 100. The shape and dimensions of the OSA package body 100 are designed to accommodate a POF alignment lock nut and a Tx laser diode TO can. As such, the OSA package body 100 has a POF lock nut recess hole (e.g., a first cavity of the package body) 140 and a TO can recess hole (e.g., a second cavity of the package body) 130.

The OSA package body 100 is designed to have a 30 degrees tilt angle 150 from the plane of the base 160 of the OSA package body 100 (e.g., from the plane of the mounting surface (or bottom surface) 160 of the OSA package body 100). The OSA package body 100 is tilted to allow for more space for electronic components on the Tx OMC PCB, without affecting the optimum optical alignment position of the POF to the laser diode inside the TO can.

The bottom side of the tilted Tx OSA package body 100 has two small (or one large) threaded holes 170 for securely mounting the Tx OSA package body 100 onto the Tx OMC PCB. The OSA package body 100 is made from a cool poly material, which is a high thermal conductivity, non-conducting polymer material. The OSA package body 100 is fabricated by a high volume, low cost, precision molding process. The TO can and the POF lock nut are inserted into the cavities 130, 140, respectively, of the OSA package body 100, and attached to the OSA package body 100 by mil spec grade epoxy. The body has a POF glue hole (e.g., a third cavity of the package body) 180 in the middle to fill in mil spec grade epoxy for holding the POF in the groove hole 190 of OSA package body 100, and for also providing an environmental seal of the bare portion of the POF inside the alignment groove 190.

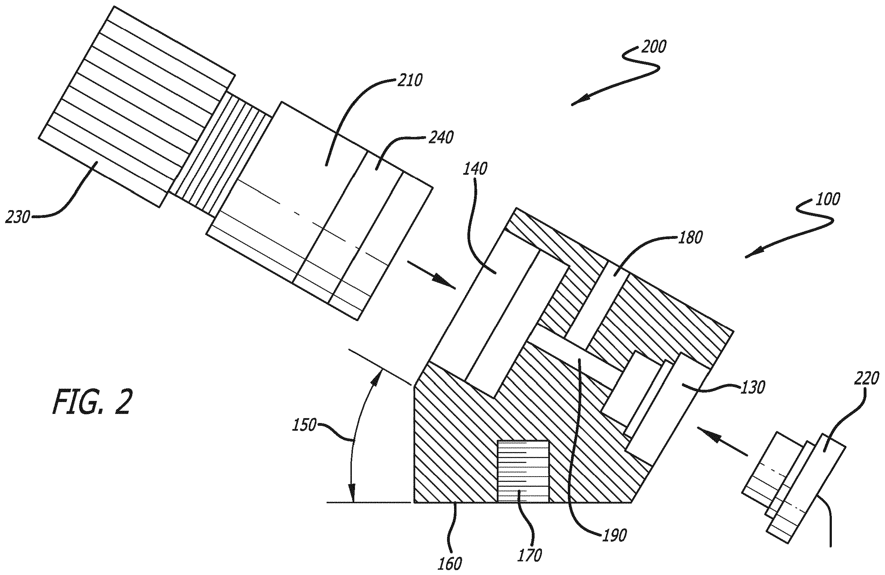

FIG. 2 is a diagram 200 illustrating the assembly process of the disclosed OSA, in accordance with at least one embodiment of the present disclosure. In particular, FIG. 2 shows a POF lock nut 210 and a laser Tx TO can 220 to be inserted into the first cavity 140 and the second cavity 130, respectively, of the OSA package body 100 of FIG 1. The lock nut 210 has a turning knob 230 for locking the POF inserted into the OSA package body 100. The lock nut 210 has two rectangular anti-rotation flanges 240 located on two sides of the lock nut 210.

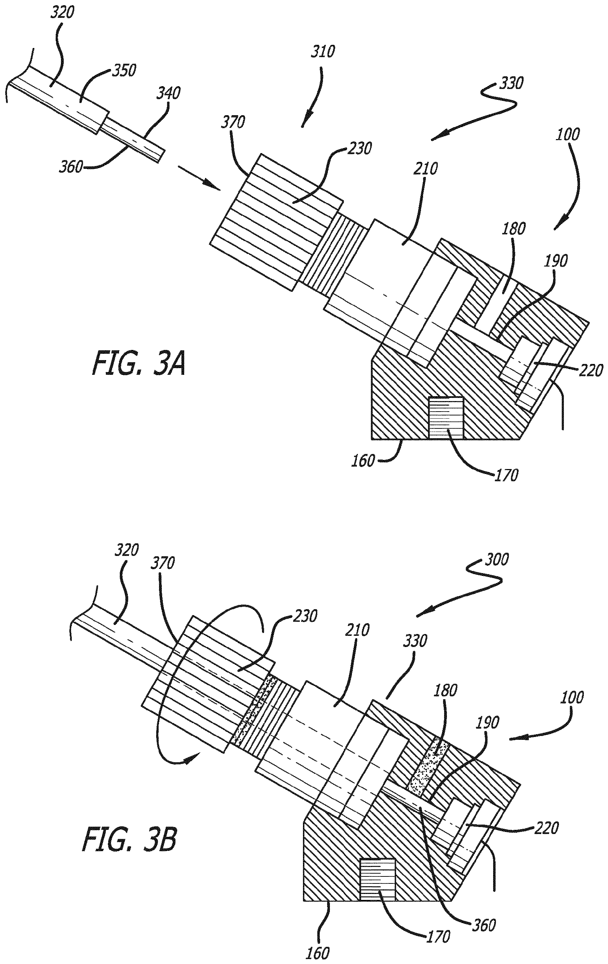

FIGS. 3A and 3B are additional diagrams 300, 310 illustrating the assembly process of the disclosed OSA, in accordance with at least one embodiment of the present disclosure. In particular, FIG. 3A shows an assembled OSA 330 with a POF 320 ready to be inserted, and FIG. 3B shows the POF 320 inserted into the assembled OSA 330 through the lock nut 210 and fitted into the POF groove 190, where the POF 320 is aligned precisely to the laser in the Tx TO can 220. The POF 320 has a core diameter 340 of about 1 millimeter (mm) and the jacketed diameter 350 of about 2.2 mm. The diameter of the POF groove 190 is designed to closely match the diameter of the POF core 340. The jacket of the POF 320 is stripped off a small section at the tip 360 to allow the core insertion in the POF groove 190. After insertion of the POF 320 into the OSA package body 100, the knob 230 of the lock nut 210 is turned to secure the POF 320 to the OSA package body 100. Additionally, mil spec grade epoxy is filled in the OSA body glue hole (e.g., the third cavity of the package body) 180 to permanently attach the POF 320 to the tilted OSA package body 100. The epoxy also provides an environmental seal for a portion of the POF 340 and the TO can 220 interface. Epoxy can optionally be added to the end 370 of the lock nut 210 to prevent loosening of the knob 230 during operation of the data BiB. The assembled OSA 330 requires no POF connector to mate with the Tx laser TO can 220. This eliminates the cost associated with POF connectors, and also eliminates the requirement for the space needed for the POF connectors inside of the data BiB.

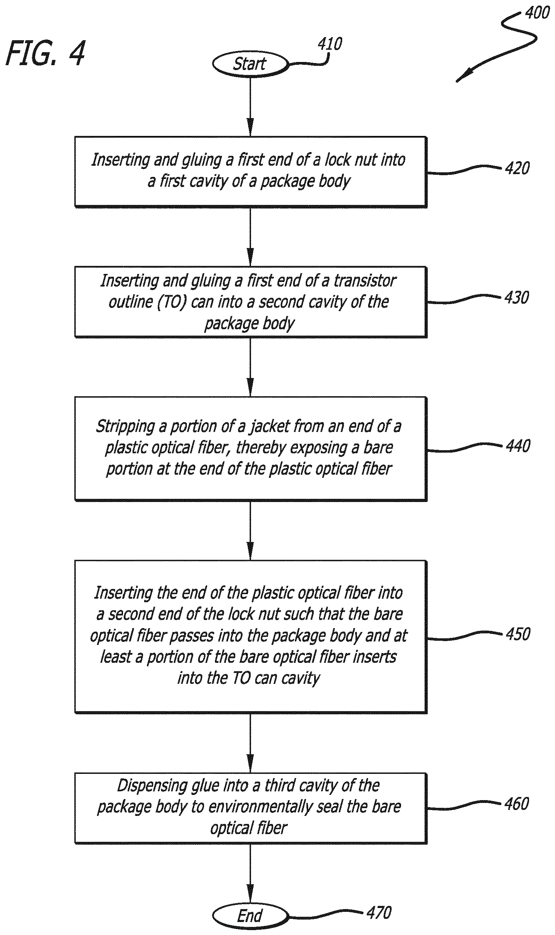

FIG. 4 is a flow chart of the disclosed method 400 for manufacturing an OSA, in accordance with at least one embodiment of the present disclosure. At the start 410 of the method 400, a first end of a lock nut is inserted into (and glued to) a first cavity of a package body 420. A first end of a transistor outline (TO) can is inserted into (and glued to) a second cavity of the package body 430. A portion of a jacket from an end of an optical fiber (e.g., plastic optical fiber) is stripped, thereby exposing a bare portion of the optical fiber at the end of the optical fiber 440. The end of the optical fiber (i.e. the end with the exposed bare optical fiber) is inserted into a second end of the lock nut such that the bare optical fiber passes through the package body and at least a portion of the bare optical fiber (e.g., an end face of the bare optical fiber) inserts into a cavity of the TO can 450. Glue is inserted (or dispensed) into a third cavity of the package body to environmentally seal the bare optical fiber 460. Then, the method ends.

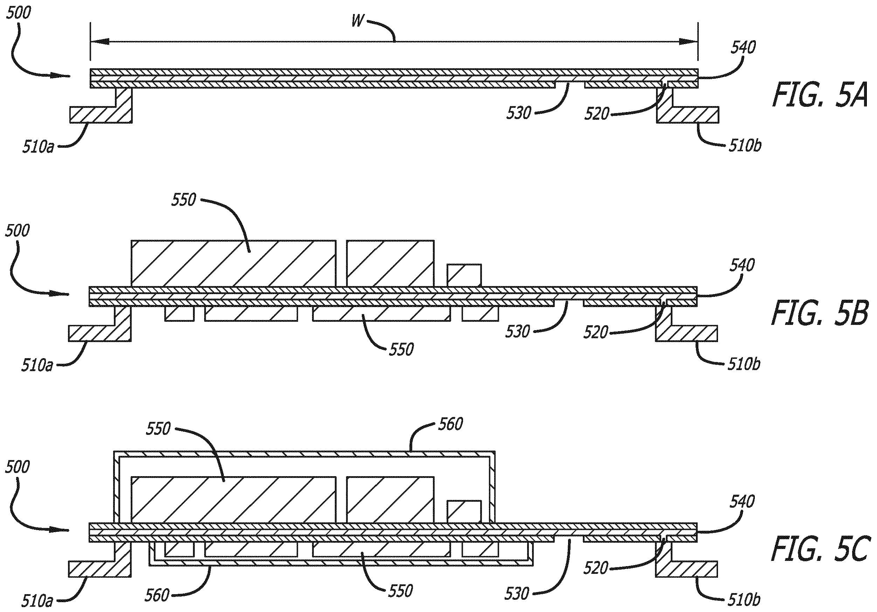

FIGS. 5A, 5B, and 5C are diagrams illustrating the transmit (Tx) optical media converter (OMC) printed circuit board (PCB) design and assembly process, in accordance with at least one embodiment of the present disclosure. Specifically, FIG. 5A shows a Tx PCB (e.g., a 2" x 1" double sided PCB with a copper core 540) 500 with two set of metal pins 510a, 510b on its sides. These pins 510a, 520b may be pins of various shapes (e.g., L-bend shaped, J-bend shaped, and/or straight pins) that are compatible with the low cost and highly reliable PCB surface mounting (SMT) processes. The PCB 500 has thermal via holes 520 that connect the set of the metal pins 510b to the copper core 540 of the PCB 500 for thermal conduction and heat sinking to the mother board of the data BiB. Another set of electrically insulated metal pins 510a connects the signal and power lines of the Tx OMC PCB 500 to the BiB mother board. The PCB 500 also has a screw hole 530 for mounting a Tx OSA onto the Tx PCB 500.

FIG. 5B shows electronic components 550 assembled (e.g., mounted) on both sides of the Tx OMC PCB 500 by using, for example, SMT technology. FIG. 5C shows electromagnetic interference (EMI) protection metal lids 560 assembled (e.g., mounted) on both the top and bottom sides of the Tx PCB 500.

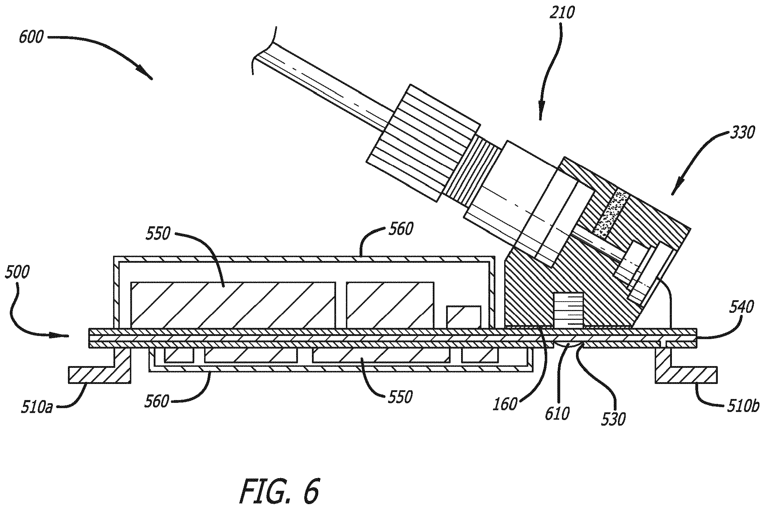

FIG. 6 is a diagram 600 showing the assembly process of mounting a Tx OSA 330 (refer to FIGS. 3A and 3B) to a Tx OMC PCB 500 (refer to FIGS. 5A, 5B, and 5C), in accordance with at least one embodiment of the present disclosure. In particular, FIG. 6 shows a tilted Tx OSA 330 attached onto a Tx PCB 500, which, for example, is assembled as shown in FIG. 5. Before the Tx OSA 330 is mechanically attached to the Tx PCB 500, mil spec grade, thermally conductive, epoxy is applied to the bottom side 160 of the Tx OSA 330. Then, the Tx OSA 330 is attached to the Tx PCB 500 via a mounting screw 610 placed into the pre-made mounting hole 530 on the Tx PCB 500. After the epoxy has cured, the Tx OSA 330 is permanently attached to the surface the Tx PCB 500. Because of the tilting of the POF in the Tx OSA 330, the POF fiber and the lock nut 210 are not taking any space on the Tx PCB 500, thereby leaving a lot of extra area for mounting electronic components onto the Tx PCB 500.

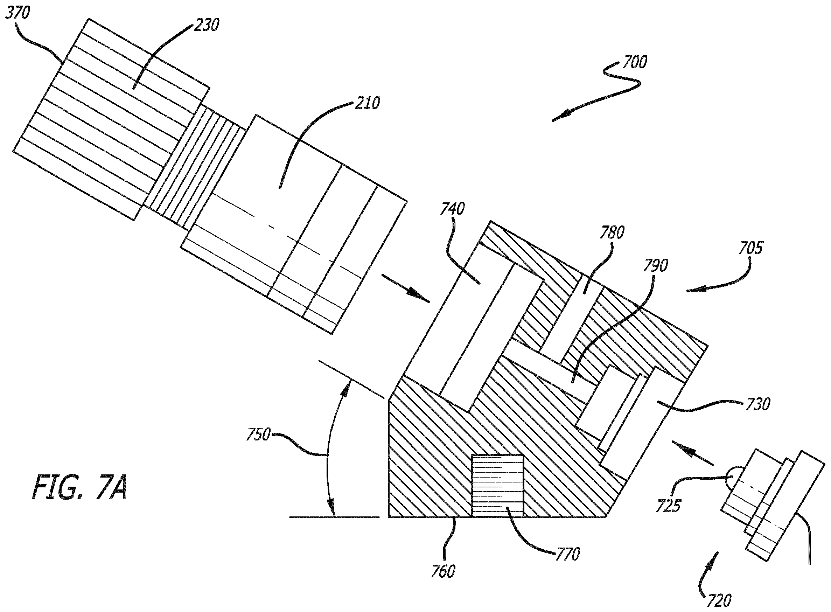

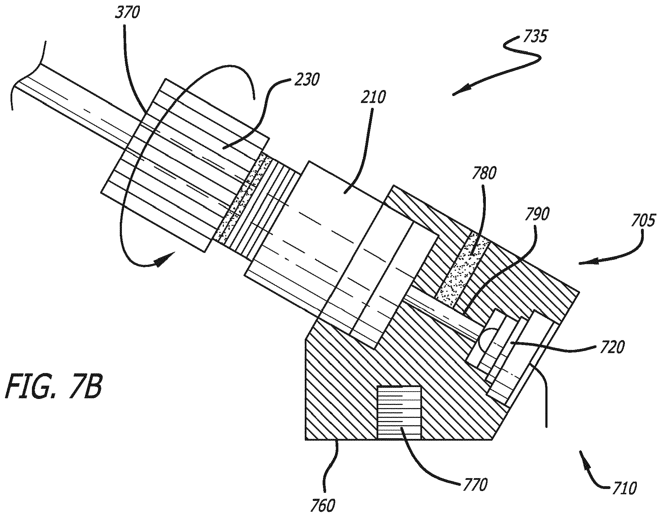

FIGS. 7A and 7B are diagrams 700, 710 illustrating the assembly process of a receiver (Rx) OSA, in accordance with at least one embodiment of the present disclosure. Specifically, FIGS. 7A and 7B show a tilted Rx OSA 735 design, which is similar to the Tx OSA 330 design described in FIGS. 3A and 3B. In particular, FIG. 7B shows an assembled Rx OSA 735 ready for POF insertion, and FIG. 7A shows a lock nut 210 ready to be inserted into a POF lock nut recess hole (e.g., a first cavity of the package body) 740 in the Rx OSA package body 705.

The Rx OSA package body 705 houses the Rx TO can 720, which has a lens cap 725. The size of the recess region (e.g., a second cavity of the package body) 730 of Rx OSA package body 705 has to precisely fit the Rx TO can 720 and to center the lens of the TO can 720 at an optimum distance from the center of the end face of the POF. This distance is crucial to achieve over -34 decibel-milliwatts (dBm) or higher receiver sensitivity for the Rx OMC.

The OSA package body 705 is designed to have a 30 degrees tilt angle 750 from the plane of the base 760 of the OSA package body 705 (e.g., from the plane of the mounting surface (or bottom surface) 760 of the OSA package body 705). The OSA package body 705 is tilted to allow for more space for electronic components on the Rx OMC PCB, without affecting the optimum optical alignment position of the POF to the detector inside the TO can.

The bottom side of the tilted Rx OSA package body 705 has two small (or one large) threaded holes 770 for securely mounting the Rx OSA package body 705 onto the Rx OMC PCB. The OSA package body 705 is made from a cool poly material, which is a high thermal conductivity, non-conducting polymer material. The OSA package body 705 is fabricated by a high volume, low cost, precision molding process.

A POF (not shown) is to be inserted into the assembled Rx OSA 735 through the lock nut 210 and fitted into the POF groove 790, where the POF is aligned precisely to the detector in the Rx TO can 220. The POF has a core diameter of about 1 millimeter (mm) and the jacketed diameter of about 2.2 mm. The diameter of the POF groove 190 is designed to closely match the diameter of the POF core. The jacket of the POF is stripped off a small section at the tip to allow the core insertion in the POF groove 190. After insertion of the POF into the OSA package body 705, the knob 230 of the lock nut 210 is turned to secure the POF to the OSA package body 705. Additionally, mil spec grade epoxy is filled in the OSA body glue hole (e.g., the third cavity of the package body) 780 to permanently attach the POF to the tilted OSA package body 705. The epoxy also provides an environmental seal for the POF and TO can 720 interface. Epoxy can optionally be added to the end 370 of the lock nut 210 to prevent loosening of the knob 230 during operation of the data BiB. The assembled OSA 735 requires no POF connector to mate with the Rx detector TO can 720. This eliminates the cost associated with POF connectors, and also eliminates the requirement for the space needed for the POF connectors inside of the data BiB.

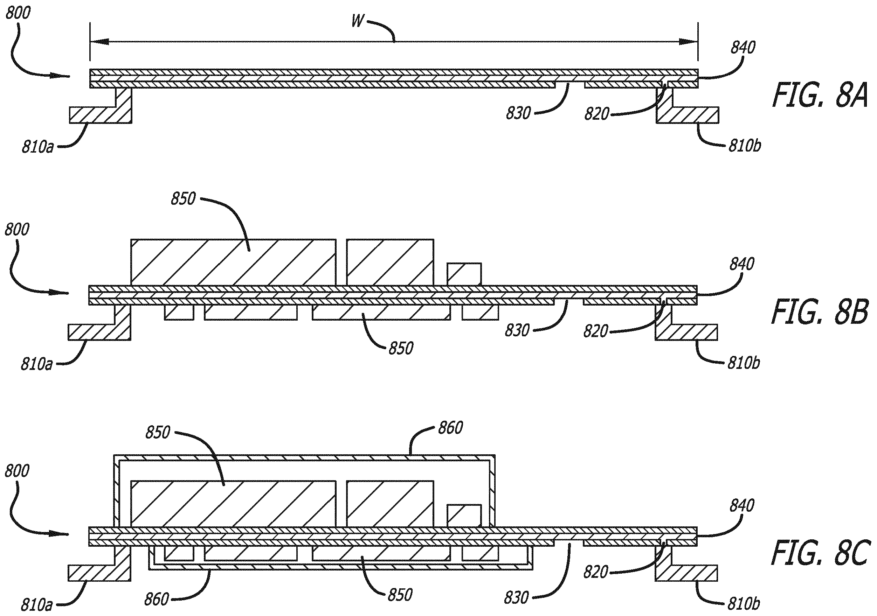

FIGS. 8A, 8B, and 8C are diagrams illustrating the Rx OMC PCB design and assembly process, in accordance with at least one embodiment of the present disclosure. In particular, FIGS. 8A, 8B, and 8C show the Rx OMC PCB design and assembly process, which are similar to the Tx OMC PCB assembly process shown in FIGS. 5A, 5B, and 5C; except for FIGS. 8A, 8B, and 8C, the electronic components are selected for use with the Rx OMC.

Specifically, FIG. 8A shows a Rx PCB (e.g., a 2" x 1" double sided PCB with copper core 840) 800 with two set of metal pins 810a, 810b on its sides. Pins 810a, 820b may be pins of various shapes (e.g., L-bend shaped, J-bend shaped, and/or straight pins) that are compatible with the low cost and highly reliable PCB surface mounting (SMT) processes. The PCB 800 has thermal via holes 820 that connect the set of the metal pins 810b to the copper core 840 of the PCB 800 for thermal conduction and heat sinking to the mother board of the data BiB. Another set of electrically insulated metal pins 810a connects the signal and power lines of the Rx OMC PCB 800 to the BiB mother board. The PCB 800 also includes a screw hole 830 for mounting a Rx OSA onto the Rx PCB 800. FIG. 8B shows electronic components 850 assembled on both sides of the Rx OMC PCB 800 by using, for example, SMT technology. FIG. 8C shows electromagnetic interference (EMI) protection metal lids 860 assembled on both the top and bottom sides of the Rx PCB 800.

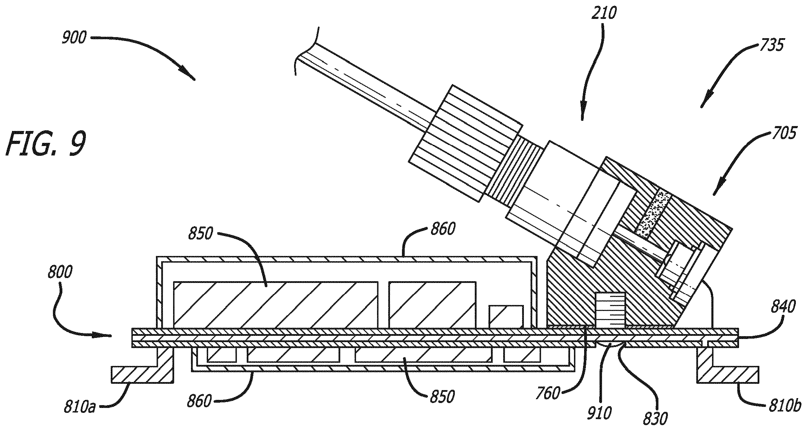

FIG. 9 is a diagram showing the assembly process of mounting an Rx OSA 735 to a Rx OMC PCB 800, in accordance with at least one embodiment of the present disclosure. Specifically, FIG. 9 shows an Rx OMC PCB assembly 735 with a tilted Rx OSA package body 705 attached to a Rx OMC PCB 800 by using the same process steps for the Tx OSA 330 as described in FIG. 6. The the tilted Rx OSA's fiber lock nut 210 does not occupy any space on the Rx PCB 800 and, as such, this provides the maximum space allocation for the electronic components on the Rx PCB 800.

In particular, FIG. 9 shows a tilted Rx OSA 735 attached onto an Rx PCB 800, which, for example, is assembled as shown in FIGS. 7A and 7B. Before the Rx OSA 735 is mechanically attached to the Rx PCB 800, mil spec grade epoxy is applied to the bottom side 760 of the Rx OSA 735. Then, the Rx OSA 735 is attached to the Rx PCB 800 via a mounting screw 910 placed into the pre-made mounting hole 830 on the Rx PCB 800. After the epoxy has cured, the Rx OSA 735 is permanently attached to the surface the Rx PCB 800.

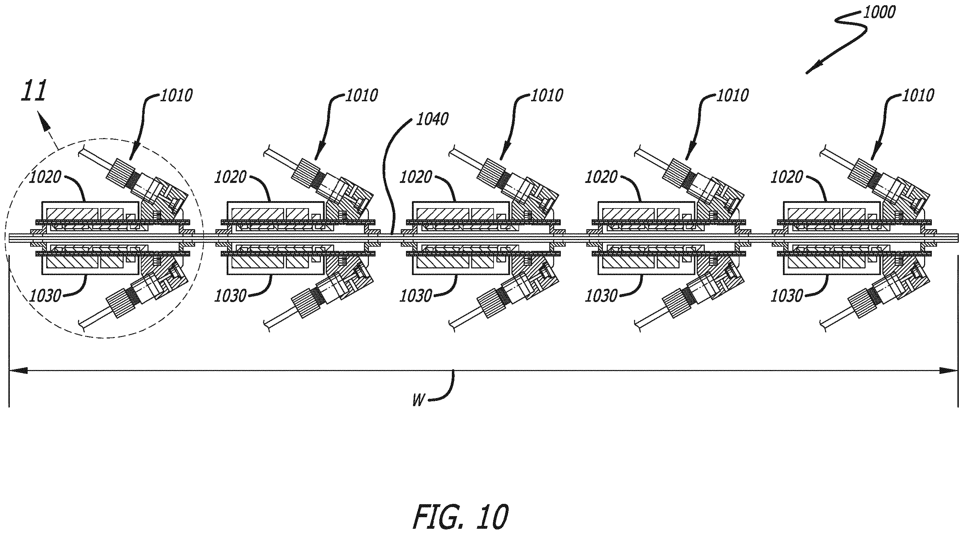

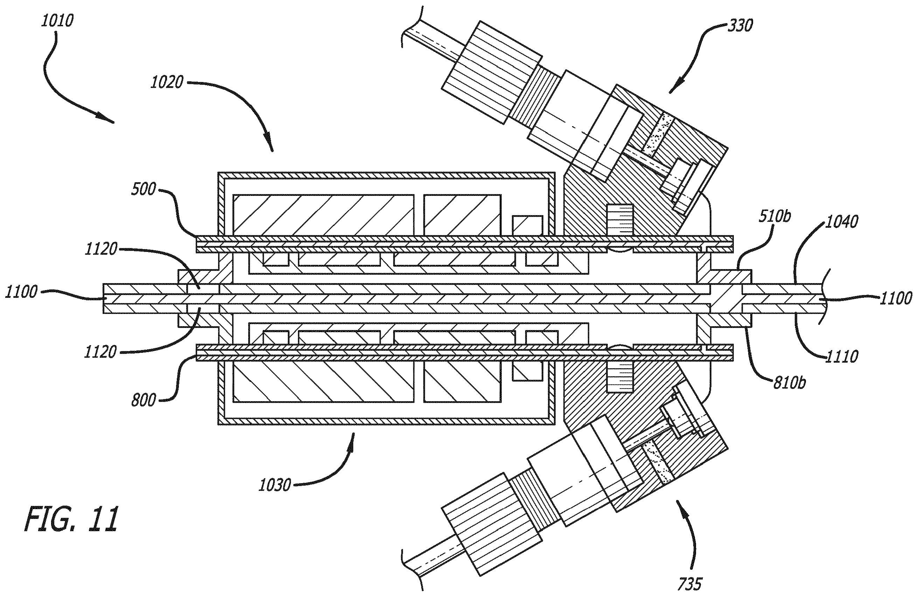

FIG. 10 is a diagram 1000 showing the assembly of optical media converters (OMCs) 1010 (comprising Tx OMC portions 1020 and Rx OMC portions 1030) mounted onto a copper core PCB mother board 1040, in accordance with at least one embodiment of the present disclosure. In particular, FIG. 10 shows the top view of one (1) row of Tx OMC portions 1020 of an OMC 1010 and 1 row of Rx OMC portions 1030 of an OMC 1010 attached to a 12.5" width (W) by 7" height (H) PCB mother board 1040 of the data BiB. The details of a single OMC 1010 will be described in detail in the description of FIG. 11.

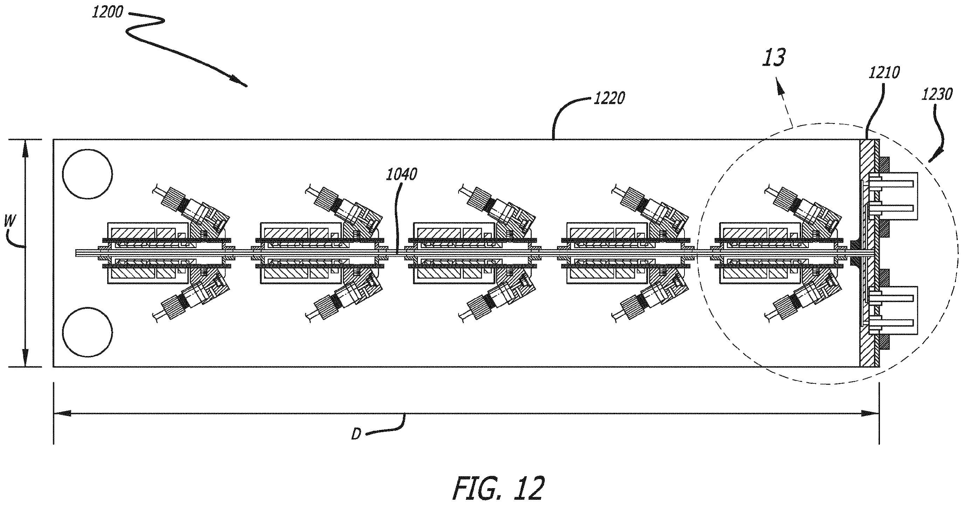

FIG. 11 is a diagram showing the details of a OMC (comprising a Tx OMC portion 1020 and an Rx OMC portion 1030) 1010 mounted onto a copper core 1100 PCB mother board 1040, in accordance with at least one embodiment of the present disclosure. As shown in FIG. 11, the data BiB mother board 1040 is a two-sided PCB with a thick copper core 1100 for maximum thermal heat sinking of the Tx OMC PCB 500 and the Rx OMC PCB 800 to the data BiB back plane (refer to 1210 of FIG. 12). The mother board 1040 has thermal via holes 1110 to connect the Tx OMC thermal pins 510b and the Rx OMC thermal pins 810b to the copper core 1100 of the mother board 1040.

The mother board 1040 also has signal via hole 1120 for connecting the signal (e.g. by using a signal wire) from the Tx OMC PCB 500 to the Rx OMC PCB 800, and vice versa. An under filling process is used to add thermal conductive and electrical insulating epoxy between the bottom of the Tx OMC PCB 500 and the mother board 1040 for mechanical strength enhancement and heat sinking of Tx OMC PCB 500 to the mother board 1040. In addition, an under filling process is used to add thermal conductive and electrical insulating epoxy between the bottom of the Rx OMC PCB 800 and the mother board 1040 for mechanical strength enhancement and heat sinking of Rx OMC PCB 800 to the mother board 1040.

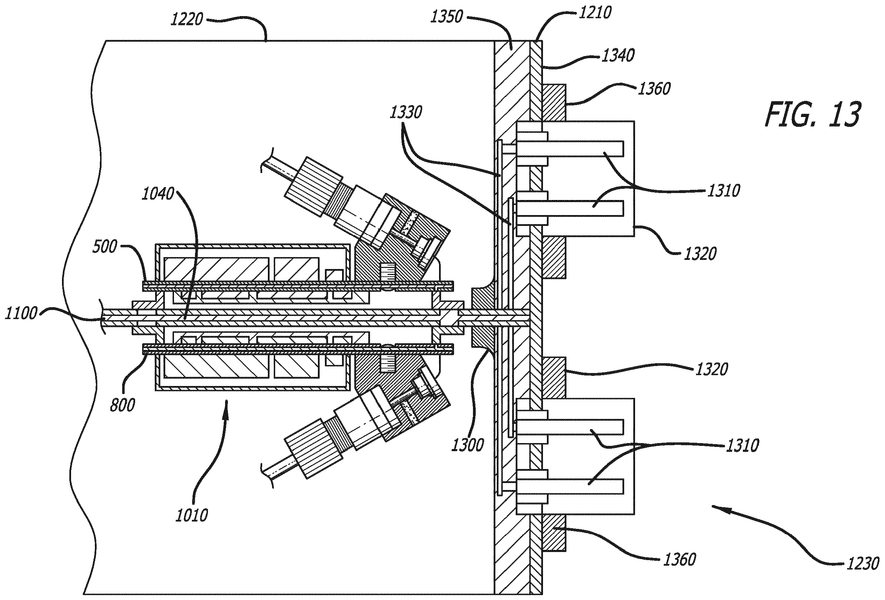

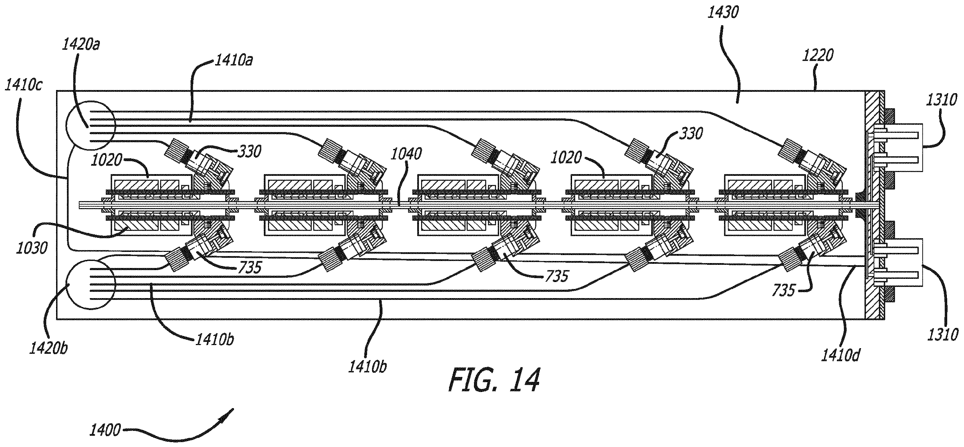

Referring back to FIG. 10, the mother board 1040 is designed such that one side will have all Rx OMC portions 1030 and the opposite side will have all Tx OMC portions 1020. This way, the connections of the POF to the Rx OMC portions 1030 and the connections of the POF to the Tx OMC portions 1020 will not need to cross over the mother board 1040 in the middle of the data BIB. This feature will be more clearly shown in FIG. 14. The mother board 1040 for the disclosed data BiB accommodates 30 (i.e. 5 columns x 6 rows) Tx OMC portions 1020 on one side and 30 (i.e. 5 columns x 6 rows) Rx OMC portions 1030 on the opposite side. This allows for a total of 30 OMCs 1010 with full Tx and Rx operation on a single mother board 1040. An alternative arrangement of 3 columns x 10 rows OMC portions on each side of the mother board 1040 is also acceptable for the disclosed data BiB design. FIG. 12 is a diagram 1200 showing the assembled PCB mother board 1040 inserted into the back plane 1210 of a 3 MCU sized data bus-in-a-box (BiB) 1220, in accordance with at least one embodiment of the present disclosure. In particular, FIG. 12 shows the completely populated mother board 1040 inserted into the backplane 1210 of a 3 MCU sized data BiB 1220 with a width (W) of 3.56" and a depth (D) of 12.76" and a height (H) of 7.64". It should be noted that 4 MCU sized data BiB with a 4.88" width is an acceptable alternative size, if the airplane space allocation is permitted. Section 1230 of FIG. 12 will be described in detail in the description of FIG. 13.

FIG. 13 is a diagram 1230 showing the details of the assembled PCB mother board 1040 inserted into the back plane 1210 of a 3 MCU sized data BiB 1220, in accordance with at least one embodiment of the present disclosure. In this figure, the mother board 1040 is inserted into a back plane connector 1300 to connect to, via power and signal electrical traces 1330, the power and signal pins 1310 of the LRU connectors 1320 at the back of the data BiB 1220. A guide rail (not shown) on a top and bottom edge of the mother board 1040 is used to guide and align the mother board 1040 to the back plane connector 1300. The data BiB back plane 1210 has a back plane PCB 1350 with a thermal conduction back layer 1340, which is attached to the back wall of the data BiB 1220. This thermal conduction back layer 1340 may be a metal plate or a thick copper layer on the back of the back plane PCB 1350. The copper core 1100 of the PCB mother board 1040 is connected to the thermal conduction back layer 1340 of the back plane PCB 1350 to conduct heat away from the Tx OMC PCB 500 and the Rx OMC PCB 800 to the back side of the data BiB 1220. The back of the data BiB 1220 is externally cooled by a convection airflow system in the airplane. The air flow capacity is thermally designed to remove heat efficiently away from the Tx OMC PCB 500 and the Rx OMC PCB 800.

There are six LRU electrical connectors 1320 mounted to the data BiB via electrical connector mounting flanges 1360. Each electrical connector 1320 provides minimum of twenty-four (24) electrical pins 1310 to connect with six OMCs 1010. As such, five electrical connectors 1320 are used to connect the 30 OMCs 1010 with 30 LRUs in an exemplary modern aircraft system bus. There is one optical connector (not shown) that is used to connect the front data BiB 1220 (located in the front of the aircraft) to the back data BiB, which is similar in design to the front data BiB 1220 but has fewer OMC, (located in the back of the aircraft) for the modern aircraft system data bus via two POF cables, which are each 60 meters in length.

Figure 13 shows a top view of the data BiB back plane 1210 with the electrical connector 1320 locations. An optical connector (not shown) would be located below the electrical connectors 1320 on the data BiB 1220. The data BiB back plane PCB 1350 is multi-layer structure with embedded power and signal electrical traces 1330 to connect the metal pins 1310 of the electrical connectors 1320 to the mother board 1040, which is connected to all of the fully assembled OMCs 1010. The mother board 1040 has metal pads on its edge to connect with the back plane's 1210 embedded metal traces 1330.

The alternative approach for connection of the data BiB 1220 mother board 1040 to the electrical connectors 1320 is by using a flexible (flex) circuit. This would be an acceptable approach if the thermal conductivity as well as the material and fabrication cost are compatible with using a back plane connector 1210.

FIG. 14 is a diagram 1400 showing the connections of POF cables 1410a, 1410b, 1410c, 1410d from POF star couplers 1420a, 1420b to the Tx OMC portions 1020 and the Rx OMC portions 1030 and to optical connectors 1430 on the side of the data BiB 1220, in accordance with at least one embodiment of the present disclosure. In particular, FIG. 14 shows the details of the POF 1410a, 1410b, 1410c, 1410d connections of the POF star couplers 1420a, 1420b to the tilted OSAs 330, 735. The POF star couplers 1420a, 1420b are each a tapered dual-star-in-one design. POF star coupler 1420a uses POF 1410a to connect to all of the Tx OSA portions 1020 on one side of the mother board 1040, and POF star coupler 1420b uses POF 1410b to connect to all of the Rx OSA portions 1030 on the opposite side of the mother board 1040. This data BiB 1220 OMC 1010 layout prevents the POF 1410a, 1410b from needing to cross over the mother board 1040. It should be noted that a mother board design with Tx OMC portions and Rx OMC portions co-located on the same side of the mother board would require the POF to cross-over the mother board in order to fully connect all the OMCs to the POF star couplers.

POF 1410c, 1410d are used to connect the POF star couplers 1420a, 1420b to an optical connector (not shown) located on the back side of the data BiB 1220. These POF 1410c, 1410d are used to connect the data BiB 1220 located in the back section of the modern aircraft system data bus. The data BiB located in the back section of the modern aircraft also has a POF star coupler 1410 that connects with a minimum of two OMCs 1010 at the back section of the airplane. The design and fabrication process of the data BiB 1220 located in the back of the airplane will be similar to the data BiB 1220 located in the front of the airplane, except the back data BiB 1220 will employ a smaller sized box than the front data BiB 1220. After the POF connections 1410a, 1410b, 1410c, 1410d to the POF star couplers 1420a, 1420b have been completed and tested, a light weight, thermally conductive and electrically insulating foam material 1430 is used to fill in the space between the mother board 1040 and the side walls of the data BiB 1020. The foam material 1430 adds an additional thermal conduction path for the Tx OMC PCB 500 to the data BiB 1220 side wall and for the Rx OMC PCB 800 to the data BiB 1220 side wall.

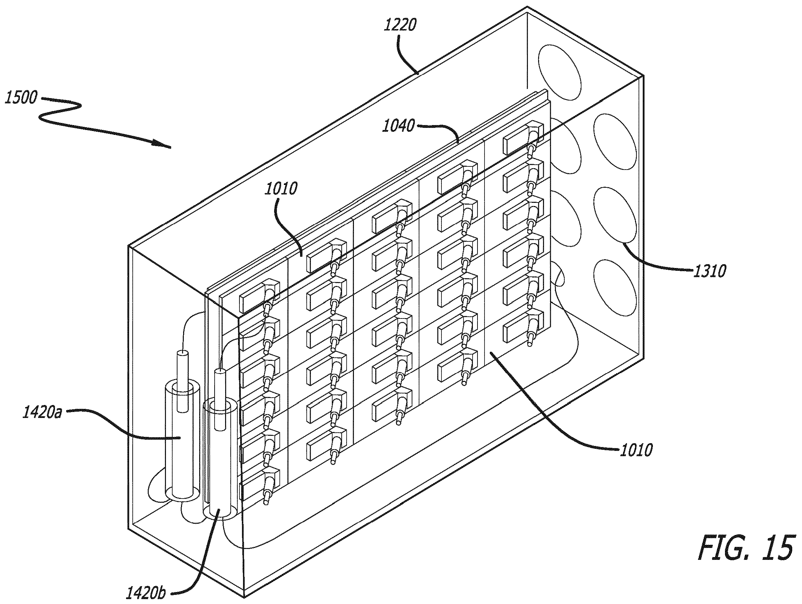

FIG. 15 is a diagram 1500 illustrating an interior view of the data BiB 1220 after final assembly, in accordance with at least one embodiment of the present disclosure. Specifically, FIG. 15 shows a schematic three dimensional (3D) conceptual view of the data BiB 1220 with 30 OMCs 1010 and a dual POF star coupler 1420a, 1420b. The POF dual star coupler 1420a, 1420b is shown in FIG. 15 to be mounted to the front side of the data BiB 1220. In alternative embodiments, the POF dual star coupler 1420a, 1420b may be mounted on the bottom side or the top side of the data BiB 1220 without a POF 1410a, 1410b, 1410c, 1410d cross over problem. Status indicator light emitting diodes (LEDs) (not shown) can be added to the back (or the front) side of the data BiB 1220 near the electrical connectors 1310 to indicate the operation status of the OMCs 1010 inside of the data BiB 1220. The OMCs 1010 (i.e. OMC PCB tiles) shown in FIG. 15 have a three (3) by (x) ten (10) tile format on each side of the mother board 1040. The approach and assembly process of the present disclosure is the same for both a 3 x 10 OMC PCB tile 1010 format and a five (5) x six (6) OMC PCB tile 1010 format on the mother board 1040 of the data BiB 1020. The overall disclosed data BiB 1020 design and assembly process is able to achieve optimum optical, thermal, and mechanical performance. The disclosed design provides a data BiB 1020 design with size, weight, power, and cost reduction for the a modern aircraft POF 629 system data bus architecture.

Although particular embodiments have been shown and described, it should be understood that the above discussion is not intended to limit the scope of these embodiments. While embodiments and variations of the many aspects of the present disclosure have been disclosed and described herein, such disclosure is provided for purposes of explanation and illustration only. Thus, various changes and modifications may be made without departing from the scope of the claims.

Where methods described above indicate certain events occurring in certain order, those of ordinary skill in the art having the benefit of this disclosure would recognize that the ordering may be modified and that such modifications are in accordance with the variations of the present disclosure. Additionally, parts of methods may be performed concurrently in a parallel process when possible, as well as performed sequentially. In addition, more parts or less part of the methods may be performed.

Accordingly, embodiments are intended to exemplify alternatives, modifications, and equivalents that may fall within the scope of the claims.

Although certain illustrative embodiments and methods have been disclosed herein, it can be apparent from the foregoing disclosure to those skilled in the art that variations and modifications of such embodiments and methods can be made without departing from the scope of the art disclosed. Many other examples of the art disclosed exist, each differing from others in matters of detail only. Accordingly, it is intended that the art disclosed shall be limited only to the extent required by the appended claims and the rules and principles of applicable law.

## Claims

1. A method for manufacturing an optical sub-assembly, OSA, the method comprising:
inserting a first end of a lock nut (210) into a first cavity (140) of a package body (100);
inserting a first end of a transistor outline, TO, can into a second cavity (130) of the package body (100);
stripping a portion of a jacket from an end of an optical fiber (320), thereby exposing bare optical fiber at the end of the optical fiber (320);
inserting the end of the optical fiber (320) into a second end of the lock nut (210) such that the bare optical fiber passes into the package body (100) and at least a portion of the bare optical fiber inserts into the second cavity (130), wherein the lock nut (210) has a turning knob (230) for locking the optical fiber inserted into the package body (100); and
dispensing glue into a third cavity (180) of the package body (100) to environmentally seal the bare optical fiber.

2. The method of claim 1, wherein the TO can (220) is a hermetically sealed TO can and the TO can comprises a lens.

3. The method of claim 1 or 2, wherein the OSA is tilted approximately thirty (30) degrees from a plane of a mounting surface for the OSA.

4. The method of any of claims 1 to 3, wherein the method further comprises:
securing, with at least one screw, a bottom side of the OSA to a mounting surface of a board by screwing the at least one screw through an opening in the board into a mounting screw hole (170) on the bottom side of the OSA, thereby mounting the OSA to the board;
wherein the board is an optical media converter, OMC, printed circuit board, PCB.

5. The method of any of claims 1 to 4, wherein the OSA is an optical transmitter or an optical receiver.

6. The method of any of claims 1 to 5, wherein the optical fiber (320), including the jacket, has a diameter (350) of approximately 1.5 millimeters (mm) to approximately 2.2 mm.

7. The method of any of claims 1 to 5, wherein the bare optical fiber, without the jacket, has a diameter (340) of approximately 1 millimeter (mm).

8. The method of claim 1, wherein the lock nut (210) has two rectangular anti-rotation flanges (240) located on two sides of the lock nut (210).

9. An apparatus for an optical sub-assembly, OSA, the apparatus comprising:
a package body (100);
a lock nut (210), wherein a first end of the lock nut (210) is inserted into a first cavity (140) of the package body (100);
a transistor outline, TO, can (220), wherein a first end of the TO can (220) is inserted into a second cavity (130) of the package body (100); and
a jacketed optical fiber (320), comprising a jacket and a bare optical fiber, wherein the bare optical fiber is exposed at an end of the jacketed optical fiber,
wherein the end of the optical fiber (320) is inserted into a second end of the lock nut (210) such that the bare optical fiber passes into the package body (100) and at least a portion of the bare optical fiber is inserted into the second cavity (130), wherein the lock nut (210) has a turning knob (230) for locking the optical fiber inserted into the package body (100), and
wherein glue is provided in a third cavity (180) of the package body (100), thereby environmentally sealing the bare optical fiber.

10. The apparatus of claim 9, wherein the TO can (220) is hermetically sealed.

11. The apparatus of claim 9 or 10, wherein the TO can (220) comprises a lens.

12. The apparatus of any of claims 9 to 11, wherein the OSA is tilted approximately thirty (30) degrees from a plane of a mounting surface for the OSA.

13. The apparatus of any of claims 9 to 12, wherein the OSA is an optical transmitter or an optical receiver.

14. The apparatus of any of claims 9 to 13, wherein the package body (100) is manufactured from a molded cool polymer material.

15. The apparatus of claim 9, wherein the lock nut (210) has two rectangular anti-rotation flanges (240) located on two sides of the lock nut (210).

## Patentansprüche

1. Verfahren zur Herstellung einer optischen Unterbaugruppe, OSA, wobei das Verfahren umfasst:
Einsetzen eines ersten Endes einer Sicherungsmutter (210) in einen ersten Hohlraum (140) eines Gehäusekörpers (100);
Einsetzen eines ersten Endes einer Transistorumrissdose, TO-Dose, in einen zweiten Hohlraum (130) des Gehäusekörpers (100);
Abziehen eines Teils einer Ummantelung von einem Ende einer optischen Faser (320), wodurch blanke optische Faser an dem Ende der optischen Faser (320) freigelegt wird;
Einführen des Endes der optischen Faser (320) in ein zweites Ende der Sicherungsmutter (210), so dass die blanke optische Faser in den Gehäusekörper (100) eintritt und mindestens ein Teil der blanken optischen Faser in den zweiten Hohlraum (130) eintritt, wobei die Sicherungsmutter (210) einen Drehknopf (230) zum Verriegeln der in den Gehäusekörper (100) eingeführten optischen Faser aufweist; und
Abgeben von Klebstoff in einen dritten Hohlraum (180) des Gehäusekörpers (100), um die blanke optische Faser gegenüber der Umgebung abzudichten.

2. Verfahren nach Anspruch 1, wobei die TO-Dose (220) eine hermetisch abgedichtete TO-Dose ist und die TO-Dose eine Linse umfasst.

3. Verfahren nach Anspruch 1 oder 2, bei dem die OSA um etwa dreißig (30) Grad aus einer Ebene einer Montagefläche für die OSA geneigt wird.

4. Verfahren nach einem der Ansprüche 1 bis 3, wobei das Verfahren ferner umfasst:
Befestigen einer Unterseite der OSA an einer Montagefläche einer Platine mit Hilfe mindestens einer Schraube durch Einschrauben der mindestens einen Schraube durch eine Öffnung
in der Platine in ein Montageschraubenloch (170) an der Unterseite der OSA, wodurch die OSA an der Platine montiert wird;
wobei die Platine eine gedruckte Leiterplatte, PCB, eines optischen Medienkonverters, OMC, ist.

5. Verfahren nach einem der Ansprüche 1 bis 4, bei dem die OSA ein optischer Sender oder ein optischer Empfänger ist.

6. Verfahren nach einem der Ansprüche 1 bis 5, bei dem die optische Faser (320), einschließlich der Ummantelung, einen Durchmesser (350) von etwa 1,5 Millimeter (mm) bis etwa 2,2 mm hat.

7. Verfahren nach einem der Ansprüche 1 bis 5, bei dem die blanke optische Faser ohne die Ummantelung einen Durchmesser (340) von etwa 1 Millimeter (mm) aufweist.

8. Verfahren nach Anspruch 1, bei dem die Sicherungsmutter (210) zwei rechteckige Verdrehsicherungsflansche (240) aufweist, die auf zwei Seiten der Sicherungsmutter (210) angeordnet sind.

9. Vorrichtung für eine optische Unterbaugruppe, OSA, wobei die Vorrichtung umfasst:
einen Gehäusekörper (100);
eine Sicherungsmutter (210), wobei ein erstes Ende der Sicherungsmutter (210) in einen ersten Hohlraum (140) des Gehäusekörpers (100) eingesetzt ist;
eine Transistorumrissdose, TO-Dose, (220), wobei ein erstes Ende der TO-Dose (220) in einen zweiten Hohlraum (130) des Gehäusekörpers (100) eingesetzt ist; und
eine ummantelte optische Faser (320), die eine Ummantelung und eine blanke optische Faser umfasst, wobei die blanke optische Faser an einem Ende der ummantelten optischen Faser freigelegt ist,
wobei das Ende der optischen Faser (320) in ein zweites Ende der Sicherungsmutter (210) eingeführt ist, so dass die blanke optische Faser in den Gehäusekörper (100) eintritt und mindestens ein Teil der blanken optischen Faser in den zweiten Hohlraum (130) eingeführt ist, wobei die Sicherungsmutter (210) einen Drehknopf (230) zum Verriegeln der in den Gehäusekörper (100) eingeführten optischen Faser aufweist, und
wobei Klebstoff in einem dritten Hohlraum (180) des Gehäusekörpers (100) vorgesehen ist, wodurch die blanke optische Faser gegenüber der Umgebung abgedichtet wird.

10. Vorrichtung nach Anspruch 9, bei der die TO-Dose (220) hermetisch abgedichtet ist.

11. Vorrichtung nach Anspruch 9 oder 10, bei der die TO-Dose (220) eine Linse umfasst.

12. Vorrichtung nach einem der Ansprüche 9 bis 11, bei der die OSA um etwa dreißig (30) Grad gegenüber einer Ebene einer Befestigungsfläche für die OSA geneigt ist.

13. Vorrichtung nach einem der Ansprüche 9 bis 12, wobei die OSA ein optischer Sender oder ein optischer Empfänger ist.

14. Vorrichtung nach einem der Ansprüche 9 bis 13, wobei der Verpackungskörper (100) aus einem geformten kühlen Polymermaterial hergestellt ist.

15. Vorrichtung nach Anspruch 9, wobei die Sicherungsmutter (210) zwei rechteckige Verdrehsicherungsflansche (240) aufweist, die auf zwei Seiten der Sicherungsmutter (210) angeordnet sind.

## Revendications

1. Procédé de fabrication d'un sous-ensemble optique, OSA, le procédé comprenant les étapes consistant à :
insérer une première extrémité d'un contre-écrou (210) dans une première cavité (140) d'un corps de boîtier (100) ;
insérer une première extrémité d'un boîtier de contour de transistor, TO, dans une deuxième cavité (130) du corps de boîtier (100) ;
enlever par stripage une partie d'une gaine à partir d'une extrémité d'une fibre optique (320), en exposant ainsi la fibre optique nue à l'extrémité de la fibre optique (320) ;
insérer l'extrémité de la fibre optique (320) dans une seconde extrémité du contre-écrou (210) de telle sorte que la fibre optique nue passe dans le corps de boîtier (100) et au moins une partie de la fibre optique nue s'insère dans la deuxième cavité (130), dans lequel le contre-écrou (210) a un bouton tournant (230) pour verrouiller la fibre optique insérée dans le corps de boîtier (100) ; et
distribuer de la colle dans une troisième cavité (180) du corps de boîtier (100) pour sceller de manière étanche à l'environnement la fibre optique nue.

2. Procédé selon la revendication 1, dans lequel le boîtier TO (220) est un boîtier TO scellé hermétiquement et le boîtier TO comprend une lentille.

3. Procédé selon la revendication 1 ou 2, dans lequel l'OSA est incliné d'environ trente (30) degrés à partir d'un plan d'une surface de montage pour l'OSA.

4. Procédé selon l'une quelconque des revendications 1 à 3, dans lequel le procédé comprend en outre l'étape consistant à :
fixer, à l'aide d'au moins une vis, un côté inférieur de l'OSA à une surface de montage d'une carte en vissant la au moins une vis à travers une ouverture dans la carte jusque dans un trou de vis de montage (170) sur le côté inférieur de l'OSA, fixant ainsi l'OSA sur la carte ;
dans lequel la carte est une carte de circuit imprimé, PCB, de convertisseur de support optique, OMC.

5. Procédé selon l'une quelconque des revendications 1 à 4, dans lequel l'OSA est un émetteur optique ou un récepteur optique.

6. Procédé selon l'une quelconque des revendications 1 à 5, dans lequel la fibre optique (320), y compris la gaine, a un diamètre (350) d'environ 1,5 millimètre (mm) à environ 2,2 mm.

7. Procédé selon l'une quelconque des revendications 1 à 5, dans lequel la fibre optique nue, sans la gaine, présente un diamètre (340) d'environ 1 millimètre (mm).

8. Procédé selon la revendication 1, dans lequel le contre-écrou (210) comporte deux brides rectangulaires anti-rotation (240) situées sur les deux côtés du contre-écrou (210).

9. Appareil pour un sous-ensemble optique, OSA, l'appareil comprenant :
un corps de boîtier (100) ;
un contre-écrou (210), dans lequel une première extrémité du contre-écrou (210) est insérée dans une première cavité (140) du corps de boîtier (100) ;
un boîtier de contour de transistor, TO, (220), dans lequel une première extrémité du boîtier TO (220) est insérée dans une deuxième cavité (130) du corps de boîtier (100) ; et
une fibre optique (320) gainée, comprenant une gaine et une fibre optique nue, dans lequel la fibre optique nue est exposée au niveau d'une extrémité de la fibre optique gainée,
dans lequel l'extrémité de la fibre optique (320) est insérée dans une seconde extrémité du contre-écrou (210) de telle sorte que la fibre optique nue passe jusque dans le corps de boîtier (100) et au moins une partie de la fibre optique nue est insérée dans la deuxième cavité (130), dans lequel le contre-écrou (210) a un bouton tournant (230) pour verrouiller la fibre optique insérée dans le corps de boîtier (100), et
dans lequel de la colle est prévue dans une troisième cavité (180) du corps de boîtier (100), en scellant ainsi la fibre optique nue vis-à-vis de l'environnement.

10. Appareil selon la revendication 9, dans lequel le boîtier TO (220) est scellé hermétiquement.

11. Appareil selon la revendication 9 ou 10, dans lequel le boîtier TO (220) comprend une lentille.

12. Appareil selon l'une quelconque des revendications 9 à 11, dans lequel l'OSA est incliné d'environ trente (30) degrés par rapport à un plan d'une surface de montage pour l'OSA.

13. Appareil selon l'une quelconque des revendications 9 à 12, dans lequel l'OSA est un émetteur optique ou un récepteur optique.

14. Appareil selon l'une quelconque des revendications 9 à 13, dans lequel le corps de boîtier (100) est fabriqué à partir d'un matériau polymère froid moulé.

15. Appareil selon la revendication 9, dans lequel le contre-écrou (210) comporte deux brides rectangulaires anti-rotation (240) situées sur les deux côtés du contre-écrou (210).
